# FASCICULE DE BREVET EUROPEEN

(11) **EP 1 712 114 B1**
(45) Date de publication et mention de la délivrance du brevet: **03.08.2011**
(21) Numéro de dépôt: 05701630.5
(22) Date de dépôt: 01.02.2005
(51) Int. Cl.: H05K 7/20, B64D 11/06

(54) **SYSTEME DE REFROIDISSEMENT D' UN BOITIER ELECTRONIQUE**
KÜHLSYSTEM FÜR EIN ELEKTRONIKGEHÄUSE
COOLING SYSTEM FOR AN ELECTRONIC BOX

(30) Priorité: 03.02.2004 FR 0401004
(43) Date de publication de la demande: 18.10.2006
(73) Titulaire: THALES, 92200 Neuilly sur Seine (FR)
(72) Inventeur: SARNO, Claude, Thales Intellectual Property, 94117 Arcueil Cedex (FR); CATROS, Jean-Yves, Thales Intellectual Property, 94117 Arcueil Cedex (FR); NOEL, Pierre, Thales Intellectual Property, 94117 Arcueil Cedex (FR)
(74) Mandataire: Esselin, Sophie
(86) Numéro de dépôt international: PCT/EP2005/050408
(87) Numéro de publication internationale: WO 2005/076685

(56) Documents cités:
- DE-A- 10 160 935
- DE-C1- 19 803 764
- GB-A- 1 563 091
- US-A- 5 409 186

## Description

Le domaine de l'invention est celui du refroidissement d'équipements électroniques, notamment lorsqu'ils sont situés dans une zone non ventilée.

Ces équipements sont par exemple des boîtiers électroniques situés sous les sièges ou dans les plafonds d'une cabine d'avion. Ces boîtiers sont notamment des éléments de systèmes de divertissement audiovisuels à la demande (films, jeux interactifs, ...), de systèmes d'accès à des services internet ainsi qu'à des services liés au vol (affichage des conditions de vol à la demande, ...), mis à la disposition du passager.

Ces équipements présentent de plus en plus de fonctionnalités et comportent de plus en plus de composants électroniques et/ou des composants plus puissants pour assurer ces fonctionnalités. Ils ont donc tendance à dissiper davantage de calories.

Or une cabine d'avion est climatisée mais non ventilée, c'est-à-dire qu'elle ne bénéficie pas de conduites d'air forcé. Se pose donc le problème du refroidissement de ces équipements.

Une première solution consiste à utiliser la convection naturelle et la dissipation de la chaleur par les sièges ou les plafonds lorsque l'installation le permet. Mais cette technique présente des risques d'obstruction des entrées d'air et ne permet de dissiper qu'un nombre réduit de calories.

Lorsque la puissance est supérieure, les boîtiers sont équipés de ventilateurs, généralement deux ventilateurs pour des raisons de fiabilité. Cela augmente le coût de fabrication du boîtier. Cela crée des problèmes de maintenance, qui augmentent avec le nombre de sièges : dans un futur proche, certains avions seront équipés de 800 sièges, ce qui représentera 1600 ventilateurs à maintenir. De plus ces ventilateurs présentent des risques d'obstruction et peuvent incommoder les passagers qui sont en face des sorties d'air. Enfin, les ventilateurs sont des équipements bruyants.

Il est connu du document US 5,409,186 un siège d'avion comportant un boîtier électronique susceptible de dégager de la chaleur et un élément connecté au boîtier de manière à dissiper la chaleur.

Un but important de l'invention est donc de refroidir des équipements électroniques situés par exemple dans une zone non ventilée, en utilisant une solution ne présentant pas les inconvénients susmentionnés.

Pour atteindre ce but, l'invention propose un système de refroidissement d'un boîtier électronique susceptible de dégager de la chaleur, principalement caractérisé en ce qu'il comprend un dispositif de refroidissement passif apte à être connecté au boîtier électronique et un élément constitué d'un matériau conducteur de chaleur et en ce que cet élément comprend au moins une zone de contact connectée au dispositif de refroidissement passif, cette zone de contact étant disposée sur l'élément de manière à dissiper la chaleur issue du dispositif de refroidissement vers l'ensemble de l'élément.

De cette façon, le chemin thermique entre les composants électroniques, le boîtier et l'élément qui dissipe la chaleur, est optimisé.

Ce système de refroidissement est silencieux, fiable car n'utilise pas d'éléments tournants ou actifs pouvant s'user, compact, ne nécessite qu'une maintenance réduite, et présente une grande souplesse d'installation.

Le dispositif de refroidissement passif est de préférence un caloduc, en particulier un caloduc à boucle diphasique.

L'invention a pour objet un siège d'avion équipé d'un système de refroidissement tel que décrit.

D'autres caractéristiques et avantages de l'invention apparaîtront à la lecture de la description détaillée qui suit, faite à titre d'exemple non limitatif et en référence aux dessins annexés dans lequels :
la figure 1 représente schématiquement des exemples de boîtiers électroniques situés dans un compartiment d'avion,
la figure 2 représente schématiquement une vue en éclaté d'un exemple de boîtier électronique selon l'invention,
la figure 3 représente schématiquement un caloduc,
la figure 4 représente schématiquement un caloduc à boucle diphasique,
la figure 5 représente schématiquement un exemple de système de refroidissement selon l'invention.

Dans la suite on va considérer que le boîtier est situé dans une zone non ventilée en l'occurence celle d'un compartiment de passagers d'un avion.

Selon l'invention, le système de refroidissement comprend un dispositif de refroidissement passif connecté d'une part au boîtier électronique à refroidir et d'autre part à la structure métallique d'accueil du boîtier, de manière à dissiper la chaleur vers cette structure.

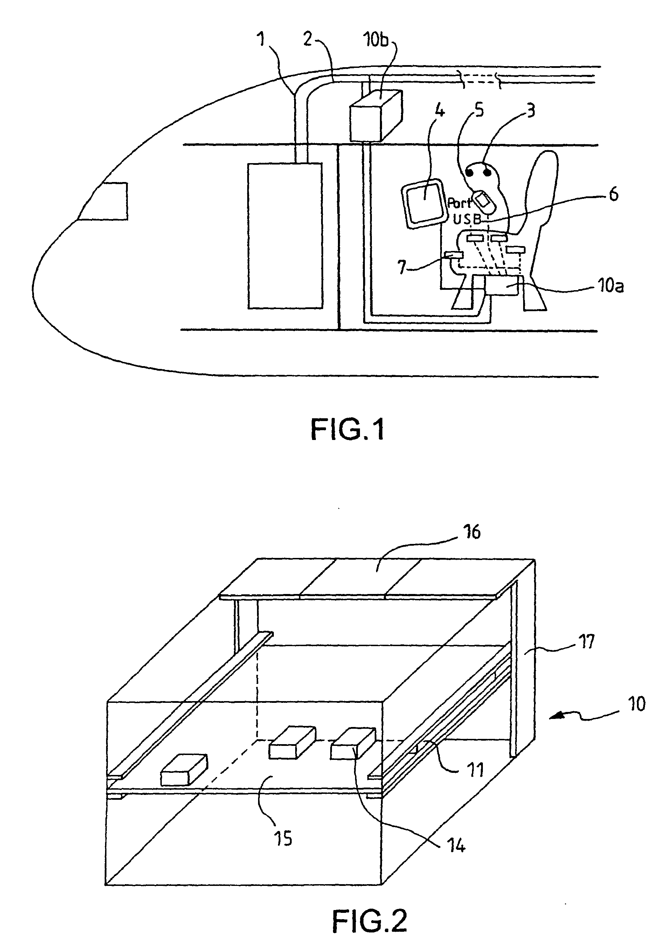

La structure d'accueil peut être un siège lorsque le boîtier est situé sous le siège ou un arceau de la structure de l'avion lorsque le boîtier est situé dans le plafond, comme illustré figure 1.

Un boîtier électronique comprend de manière classique des composants électroniques tels que des processeurs, des mémoires, ..., qui sont montés sur des circuits imprimés ou des circuits intégrés. Le boîtier peut aussi comporter d'autres composants électroniques tels qu'une carte graphique et/ou vidéo, une carte son, un disque dur, etc. On a représenté figure 1 deux exemples de boîtiers électroniques : l'un 10a situé sous le siège est relié d'une part aux réseaux centraux de l'avion électrique, ethernet 1, réseau RF 2 audio et/ou vidéo, via un autre boîtier 10b et d'autre part à divers terminaux, écouteurs audio 3, moniteur vidéo 4, télécommande 5, port USB 6 pour la connexion à un ordinateur portable, prise électrique 7, ...), l'autre 10b situé dans le plafond est relié aux réseaux centraux de l'avion et aux boîtiers électroniques 10a de plusieurs sièges.

Dans la suite on prendra comme exemple un boîtier électronique fixé sous un siège. Ce cas de figure est plus critique que le boîtier situé dans le plafond car plus difficile d'accès et plus susceptible d'être endommagé par les passagers.

Selon l'invention, le boîtier électronique 10, représenté figure 2 comporte lui-même un système de drainage de la chaleur dégagée par ses composants électroniques 14, vers une zone 16 de préférence située sur une face extérieure du boîtier et destinée à être connectée à un dispositif de refroidissement passif. Sur l'exemple de la figure 2, le système de drainage de la chaleur comprend des glissières thermiques 11 situées en bordure de circuit 15, et en contact avec les parois 17 latérales du boîtier. Ces parois latérales sont également en contact avec la paroi supérieure qui présente la zone 16 de refroidissement du boîtier. Selon ce système de refroidissement, la chaleur est drainée des composants 14 vers les glissières 11 puis vers les parois 17 puis vers la zone 16.

On peut citer comme autre exemple de système de drainage, un système connu de refroidissement à changement de phase tel qu'un caloduc, parfois utilisé pour évacuer les calories des composants vers les parois du boîtier.

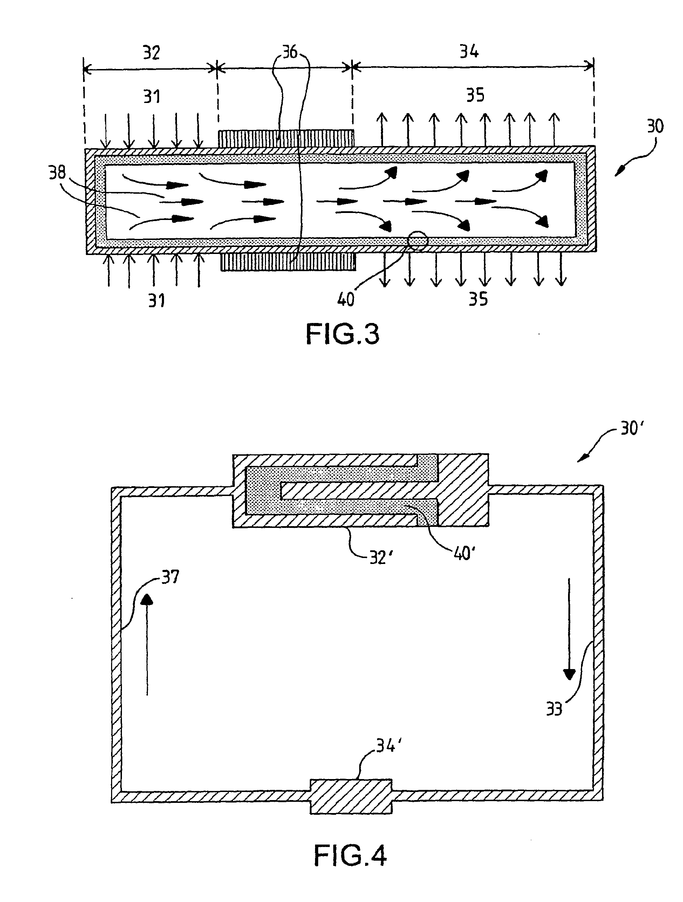

On rappelle qu'un caloduc 30 représenté, figure 3, comporte principalement un évaporateur 32 par lequel la chaleur 31 est absorbée et un condenseur 34 par lequel la chaleur 35 est dégagée. Ils sont séparés par une zone adiabatique 36. Le caloduc contient un liquide, généralement de l'eau. Lorsqu'un point de l'évaporateur est chauffé, l'eau se transforme en vapeur 38 (phase vapeur) dans l'évaporateur 32 en absorbant la chaleur ; avec la température, la pression de la vapeur augmente et la vapeur 38 circule vers le condenseur 34 plus froid, en traversant la zone adiabatique 36 ; là, la vapeur 38 se condense en eau (phase liquide), en restituant la chaleur 35 vers l'extérieur du caloduc 30 et le liquide retourne vers l'évaporateur 32 par effet capillaire, à travers une structure capillaire 40 comportant par exemple des canaux.

Lorsque le boîtier 10 est équipé d'un caloduc, la zone 16 destinée à être connectée à un dispositif de refroidissement 20 est celle du condenseur 34. Plus généralement cette zone 16 est celle où la chaleur du boîtier est drainée.

Jusqu'à présent, les caloducs sont utilisés pour refroidir des boîtiers électroniques comme indiqué précédemment, tels que des ordinateurs portables dont la température de fonctionnement atteint facilement 40° C. La distance sur laquelle la chaleur est drainée est de l'ordre de 20 cm.

Selon un mode de réalisation de l'invention, le dispositif de refroidissement passif 20 situé entre le boîtier et la structure métallique du siège, est aussi un caloduc malgré des spécificités d'utilisation inhabituelles. En effet, les spécificités d'utilisation dans le domaine aéronautique, résident dans la tenue à des températures plus élevées, pouvant atteindre 70° C pour des boîtiers d'un volume d'environ 1 ou 2 MCU (1MCU=1,6 litre), des distances de drainage de la chaleur plus longues, de l'ordre de 60 cm, et une résistance à l'accélération qui ne doit pas empêcher l'effet capillaire de se produire. Cette résistance doit être inférieure à 10 g, avec g=9,81 m/s².

Le caloduc utilisé est tel que représenté figure 3, ou une variante représentée figure 4 et désignée caloduc à boucle diphasique 30' reposant sur le même principe de fonctionnement. Dans cette variante, l'évaporateur 32' et le condenseur 34' sont reliés par une ligne 33 de circulation de la vapeur et une ligne 37 de circulation du liquide. Une pompe capillaire 40' est intégrée à l'évaporateur 32' comme illustré figure 4. Ces lignes de circulation 33 et 37 peuvent être réalisées dans un matériau déformable qui permet de relier facilement l'évaporateur 32' en contact avec la zone 16 du boîtier, au condenseur 34'. Ces lignes de circulation déformables facilitent l'installation de ce dispositif de refroidissement 20.

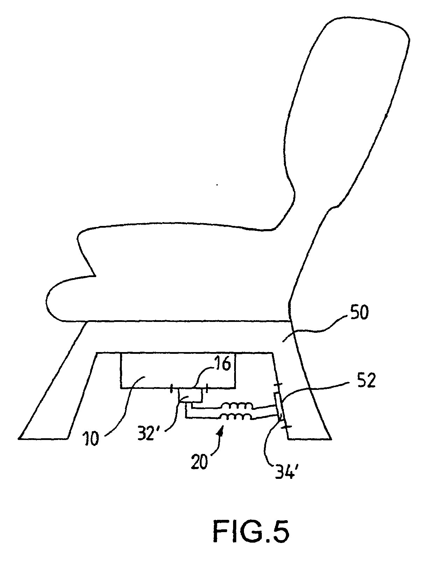

Selon l'invention, le dispositif de refroidissement 20 est relié à une partie du siège, constituée d'un matériau conducteur de chaleur, qui peut être du métal. Il s'agit par exemple des pieds du siège. Comme illustré figure 5, cette partie métallique 50 comprend une zone de contact 52 destinée à être connectée au dispositif de refroidissement 20, plus précisément au condenseur 34' de ce dispositif. La chaleur issue du condenseur 34' est alors dissipée vers l'ensemble de la structure métallique 50 du siège.

De cette façon, le chemin thermique entre les composants électroniques, le boîtier et la structure métallique du siège est optimisée.

Ce système global de refroidissement est silencieux, fiable car n'utilise pas d'éléments tournants ou actifs pouvant s'user, compact, ne nécessite aucune maintenance, et présente une grande souplesse d'installation.

Selon un mode de réalisation particulier, le dispositif de refroidissement 20 comporte plusieurs condenseurs 34' et la structure d'accueil, plusieurs zones de contact 52.

## Revendications

1. Siège d'avion, le siège étant équipé d'un boîtier électronique (10) susceptible de dégager de la chaleur, et comprenant un élément (50) constitué d'un materiau conducteur de chaleur, **caractérisé en ce qu'**il comprend un dispositif de refroidissement passif (20) connecté au boîtier électronique (10), ledit élément (50) comprenant au moins une zone de contact (52) connectée au dispositif de refroidissement passif (20), cette zone de contact étant disposée sur l'élément (50) de manière à dissiper la chaleur issue du dispositif de refroidissement vers l'ensemble de élément (50).

2. Siège d'avion selon la revendication précédente, **caractérisé en ce que** le dispositif de refroidissement passif (20) est un caloduc, en particulier un caloduc à boucle diphasique.

3. Siège d'avion selon l'une quelconque des revendications précédentes, **caractérisé en ce que** le boîtier électronique (10) comporte un système interne de drainage de la chaleur relié à une zone de contact (16) du boîtier et **en ce que** cette zone de contact (16) est connectée au dispositif de refroidissement passif (20).

4. Siège d'avion selon l'une quelconque des revendications 2 ou 3, **caractérisé en ce que** le boîtier électronique (10) comporte des parois et **en ce que** la zone de contact (16) est une partie d'une paroi.

## Claims

1. An aircraft seat, said seat being equipped with an electronic unit (10) designed to release heat and comprising an element (50) constituted by a heat conducting material, **characterised in that** it comprises a device for passive cooling (20) connected to said electronic unit (10), said element (50) comprising at least one contact zone (52) connected to the device for passive cooling (20), said contact zone being arranged on said element (50) so as to dissipate the heat originating from the cooling device over the entire element (50).

2. The aircraft seat according to the preceding claim, **characterised in that** the device for passive cooling (20) is a heat pipe, more specifically a diphasic circuit heat pipe.

3. The aircraft seat according to any one of the preceding claims, **characterised in that** the electronic unit (10) comprises an internal heat drainage system connected to a contact zone (16) of the unit, and **in that** said contact zone (16) is connected to the device for passive cooling (20).

4. The aircraft seat according to any one of claims 2 or 3, **characterised in that** the electronic unit (10) comprises walls and **in that** the contact zone (16) is a section of a wall.

## Patentansprüche

1. Flugzeugsitz, wobei der Sitz mit einer Elektronikeinheit (10) zum Abgeben von Wärme ausgestattet ist und ein Element (50) aus einem wärmeleitenden Material umfasst, **dadurch gekennzeichnet, dass** er eine mit dem Elektronikgehäuse (10) verbundene Vorrichtung (20) zum passiven Kühlen umfasst, wobei das Element (50) wenigstens eine mit der Vorrichtung (20) zum passiven Kühlen verbundene Kontaktzone (52) umfasst, wobei diese Kontaktzone so an dem Element (50) angeordnet ist, dass die von der Kühlvorrichtung kommende Wärme zum gesamten Element (50) hin abgeführt wird.

2. Flugzeugsitz nach dem vorherigen Anspruch, **dadurch gekennzeichnet, dass** die Vorrichtung (20) zum passiven Kühlen ein Wärmerohr, spezieller ein Wärmerohr mit Zweiphasenkreislauf ist.

3. Flugzeugsitz nach einem der vorherigen Ansprüche, **dadurch gekennzeichnet, dass** das Elektronikgehäuse (10) ein internes Wärmeabführsystem umfasst, das mit einer Kontaktzone (16) des Gehäuses verbunden ist, und **dadurch**, dass diese Kontaktzone (16) mit der Vorrichtung (20) zum passiven Kühlen verbunden ist.

4. Flugzeugsitz nach Anspruch 2 oder 3, **dadurch gekennzeichnet, dass** das Elektronikgehäuse (10) Wände umfasst, und **dadurch**, dass die Kontaktzone (16) ein Teil einer Wand ist.
